# EUROPÄISCHE PATENTANMELDUNG

(11) **EP 4 704 505 A1**
(43) Veröffentlichungstag der Anmeldung: **04.03.2026**
(21) Anmeldenummer: 24197624.0
(22) Anmeldetag: 30.08.2024
(51) Int. Cl.: H05K 7/20

(54) **STROMRICHTERMODUL UND BETRIEBSVERFAHREN**

(71) Anmelder: Siemens Aktiengesellschaft, 80333 München (DE)
(72) Erfinder: Bigl, Thomas, 91074 Herzogenaurach (DE); Danov, Vladimir, 91056 Erlangen (DE); Grundmann, Jörn, 91091 Großenseebach (DE); Madkour, Sherif, 12159 Berlin (DE); Müller, Volker, 90459 Nürnberg (DE); Neugebauer, Stephan, 91058 Erlangen (DE); Reissner, Florian, 90411 Nürnberg (DE); Schwarz, Florian, 91466 Gerhardshofen (DE)
(74) Vertreter: Siemens Patent Attorneys

(57) **Zusammenfassung**

Es wird ein Stromrichtermodul (1) angegeben, umfassend
- ein übergeordnetes Gehäuse (3), welches eine Mehrzahl von Untermodulen (10,20,30,40) gemeinsam umschließt,
- eine Mehrzahl von elektrischen Elementen (13,23,33,43), die jeweils einem einzelnen der Untermodule (10,20,30,40) zugeordnet sind und die aus der folgenden Liste ausgewählt sind:
- leistungselektronische Schaltelemente (13),
- Schaltungsanordnungen (33) die als Gate-Treiber für ein leistungselektronisches Schaltelement ausgebildet sind,
- elektrische Kondensatoren (32) und/oder
- elektrische Spulen

- sowie eine Anzahl von Untermodulgehäusen (11,21,31), welche jeweils einem Untermodul (10,20,30) zugeordnet sind und welche die elektrischen Elemente (13,23,33) dieses Untermoduls (10,20,30) umschließen,
- wobei im Inneren der Untermodulgehäuse (11,21,31) jeweils eine Medienkammer (15,25,35) ausgebildet ist, welche mittels einer Außenwand des jeweiligen Untermodulgehäuses (11,21,31) gegen die Umgebung des jeweiligen Untermoduls (10,20,30) fluiddicht gekapselt ist,
- wobei die jeweilige Medienkammer (15,25,35) im betriebsbereiten Zustand mit einem elektrisch isolierenden fluiden Kühlmedium (M1,M2) befüllt ist,
- und wobei innerhalb wenigstens einer der vorhandenen Medienkammern (15,25,35) das fluide Kühlmedium (M1,M2) derart zirkulieren kann, dass es einen elektrisch aktiven Teilbereich eines elektrischen Elements (13,23,33) des jeweiligen Untermoduls (10,20,30) anströmt.

Weiterhin wird ein Verfahren zum Betrieb eines solchen Stromrichtermoduls (1) angegeben.

## Beschreibung

Die vorliegende Erfindung betrifft ein Stromrichtermodul mit einem übergeordneten Gehäuse, welches eine Mehrzahl von Untermodulen gemeinsam umschließt, mit einer Mehrzahl von elektrischen Elementen, die jeweils in einem Untermodul angeordnet sind, sowie mit einer Anzahl von Untermodulgehäusen, welche jeweils einem Untermodul zugeordnet sind und welche die elektrischen Elemente des jeweiligen Untermoduls umschließen.

Aus dem Stand der Technik sind vielfältige Stromrichtermodule bekannt, z.B. in Form von Vorrichtungen, die die Funktion von Wechselrichtern, Gleichrichtern oder Umrichtern erfüllen. Solche Stromrichtermodule weisen häufig ein übergeordnetes Gehäuse auf, in welchem die elektrischen Komponenten des Moduls angeordnet sind und vor äußeren Einflüssen geschützt sind. Vor allem die in solchen Modulen angeordneten leistungselektronischen Schaltelemente weisen beim Betrieb typischerweise eine hohe Verlustleistung auf, so dass die Sicherstellung einer effektiven Kühlung eine wichtige Aufgabe bei der Entwicklung solcher Module darstellt. Es besteht ein ungebrochener Trend zur Steigerung der Leistungen solcher Stromrichtermodule bei gleichzeitiger Miniaturisierung, was die Herausforderungen im Zusammenhang mit der Kühlung der elektrischen Bauelemente weiter erhöht.

Ein vergleichsweise einfacher Ansatz zur Kühlung von Stromrichtermodulen stellt die Luftkühlung dar. Hierbei wird Umgebungsluft über einen in das Stromrichtermodul eingebauten Lüfter durch das Innere des Gehäuses zirkuliert, um eine Wärmeabgabe an die Umgebung zu fördern und so die von den elektrischen Bauelementen dissipierte Wärme abzuführen. Dieser Ansatz wird häufig bei Stromrichtermodulen mit niedriger Leistung und im niedrigen Preissegment gewählt. Bei höheren Leistungsdichten kann damit jedoch meist keine ausreichende Entwärmung bewirkt werden.

Ein alternativer Ansatz zur Kühlung von Stromrichtermodulen stellt die Flüssigkeitskühlung dar. Flüssig gekühlte Stromrichtermodule sind vor allem bei industriellen Anwendungen verbreitet, bei denen die Leistungsdichten höher sind und entsprechend ein höherer apparativer und preislicher Aufwand beim Kühlsystem zu vertreten ist. Typischerweise wird dabei ein Teil der elektrischen Bauelemente thermisch mit einem Kühlköper gekoppelt. Dieser Kühlkörper enthält Kühlkanäle zur Zirkulation eines flüssigen Kühlmittels, wobei das flüssige Kühlmittel die Wärme aus dem Kühlkörper aufnehmen und in einen Bereich außerhalb des Modulgehäuses abführen kann. Das Gehäuse ist dazu entsprechend mit einem Einlass und einem Auslass für das flüssige Kühlmedium ausgestattet. Das Kühlmittel wird meist mit einer außerhalb des Modulgehäuses liegenden Pumpe durch das entsprechende Leitungssystem gepumpt. Nachteilig sind bei diesem Ansatz die Erhöhung der Schnittstellen des Moduls aufgrund der zusätzlichen Kühlmittelleitungen, der Energieverbrauch der außenliegenden Pumpe und die erhöhte Komplexität des inneren Aufbaus des Stromrichtermoduls, wobei bei der Wahl der Materialien zum Teil auch eine Kompatibilität mit dem verwendeten flüssigen Kühlmedium berücksichtigt werden muss. Auch der Wartungsaufwand eines solchen flüssiggekühlten Stromrichtermoduls ist aufgrund der höheren Komplexität im Vergleich zu einem luftgekühlten Stromrichtermodul häufig erhöht.

Aufgabe der Erfindung ist es daher, ein Stromrichtermodul anzugeben, welches die genannten Nachteile überwindet. Insbesondere soll ein Stromrichtermodul mit einem alternativen Kühlsystem zur Verfügung gestellt werden, welches eine effektive Wärmeabfuhr der enthaltenen elektrischen Komponenten bei hohen Leistungsdichten ermöglicht. Dies soll insbesondere bei einer geringen apparativen Komplexität realisiert werden und/oder einen geringen Wartungsaufwand zur Folge haben. Eine weitere Aufgabe ist es, ein Betriebsverfahren für ein solches Stromrichtermodul anzugeben, mit dem eine entsprechende Kühlung realisiert werden kann.

Diese Aufgaben werden durch das in Anspruch 1 beschriebene Stromrichtermodul und das in Anspruch 13 beschriebene Betriebsverfahren gelöst.

Das erfindungsgemäße Stromrichtermodul umfasst:
- ein übergeordnetes Gehäuse, welches eine Mehrzahl von Untermodulen gemeinsam umschließt,
- eine Mehrzahl von elektrischen Elementen, die jeweils in einem Untermodul angeordnet sind und die aus der folgenden Liste ausgewählt sind:
   - leistungselektronische Schaltelemente,
   - Schaltungsanordnungen, die als Gate-Treiber für ein leistungselektronisches Schaltelement ausgebildet sind,
   - elektrische Kondensatoren,
   - elektrische Spulen,
- sowie eine Anzahl, insbesondere eine Mehrzahl, von Untermodulgehäusen, welche jeweils einem Untermodul zugeordnet sind und welche die elektrischen Elemente dieses Untermoduls umschließen.

Dabei ist im Inneren der Untermodulgehäuse jeweils eine Medienkammer ausgebildet, welche mittels einer Außenwand des jeweiligen Untermodulgehäuses gegen die Umgebung des jeweiligen Untermoduls fluiddicht gekapselt ist. Die jeweilige Medienkammer ist im betriebsbereiten Zustand des Stromrichtermoduls mit einem elektrisch isolierenden fluiden Kühlmedium befüllt. Dabei ist wenigstens eine der vorhandenen Medienkammern so ausgestaltet, dass das fluide Kühlmedium derart zirkulieren kann, dass es einen elektrisch aktiven Teilbereich eines elektrischen Elements des jeweiligen Untermoduls anströmt.

Unter einem Stromrichtermodul wird hier ein elektrisches Gerät verstanden, das zur Umwandlung eines Eingangsstroms in einen Ausgangsstrom unter Änderung wenigstens eines Parameters ausgelegt ist. Es kann sich also insgesamt um ein elektrisches Modul mit der Funktion eines Gleichrichters zur Umwandlung von Wechselstrom in Gleichstrom, eines Wechselrichters zur Umwandlung von Gleichstrom in Wechselstrom, eines Gleichspannungswandlers (DC/DC-Wandler) zur Umwandlung von Gleichstrom in einen andersartigen Gleichstrom oder eines Umrichters (AC/AC-Konverters) zur Umwandlung von Wechselstrom in einen andersartigen Wechselstrom handeln. Diese Umwandlung erfolgt insbesondere mittels elektronischer Bauelemente auf der Basis von Halbleitermaterialien, den sogenannten Leistungshalbleitern.

Das übergeordnete Gehäuse eines solchen Stromrichtermoduls dient der Abgrenzung und dem Schutz der enthaltenen elektrischen Elemente in Bezug auf die äußere Umgebung sowie umgekehrt auch dem Schutz der Umgebung vor den Gefahren, die von den elektrischen Elementen ausgehen. In dem übergeordneten Gehäuse kann eine Hauptplatine angeordnet sein, welche die einzelnen Untermodule des Stromrichtermoduls trägt. Die beschriebenen Untermodule bilden funktional getrennte Einheiten innerhalb dieses Gehäuses. Sie sind insbesondere in räumlich voneinander getrennten Teilbereichen des Stromrichtermoduls angeordnet, insbesondere auf separaten Teilflächen einer Hauptplatine. Sie können insbesondere getrennt voneinander austauschbar sein. So kann beispielsweise ein sogenanntes "Leistungsmodul" enthalten sein, welches ein oder mehrere halbleiterbasierte leistungselektronische Schaltelemente wie beispielsweise IGBTs, Leistungs-MOSFETs oder Thyristoren umfassen kann. Alternativ oder zusätzlich kann ein sogenanntes "Kondensatormodul" enthalten sein, welches ein oder mehrere elektrische Kondensatoren umfassen kann, insbesondere zur Ausbildung eines sogenannten Zwischenkreiskondensators im Zwischenkreis eines Umrichters. Alternativ oder zusätzlich kann ein sogenanntes "Treibermodul" enthalten sein, welches ein oder mehrere Schaltungsanordnungen enthalten kann, die als Gate-Treiber zur Ansteuerung der Gate-Elektrode(n) eines oder mehrerer leistungselektronischer Schaltelemente ausgebildet sein können. Gegebenenfalls können auch mehrere der beschriebenen Funktionalitäten in einem Untermodul kombiniert sein und/oder eine solche Funktionalität kann noch feingranularer auf mehrere Untermodule aufgeteilt sein. Wesentlich ist jedoch eine Aufteilung der elektrischen Funktionalität in wenigstens zwei räumlich voneinander getrennte Untermodule. Die elektrischen Elemente der einzelnen Untermodule können beispielsweise auf separaten Untermodulplatinen angeordnet sein. Neben den in der obenstehenden Liste genannten elektrischen Elementen können jeweils auch weitere Elemente umfasst sein wie elektrische Widerstände (z.B. Shuntwiderstände zur Strommessung), Leitungen und weitere Schaltelemente.

Wenigstens eines der insgesamt vorliegenden Untermodule weisen ein eigenes Untermodulgehäuse auf, von welchem die dem jeweiligen Untermodul zugeordneten elektrischen Elemente umschlossen sind. Es ist also nicht unbedingt notwendig, dass alle vorhandenen funktionalen Untermodul-Einheiten ein separates Gehäuse aufweisen, aber für wenigstens eines der vorliegenden Untermodule trifft dies zu, bevorzugt sogar für eine Mehrzahl. Weiterhin ist wenigstens eines der vorhandenen Untermodulgehäuse als Medienkammer für ein fluides Kühlmittel ausgebildet, vorteilhaft sind auch dies insbesondere mehrere. Unter einem "fluiden" Kühlmittel soll allgemein ein flüssiges, gasförmiges oder überkritisches Kühlmittel verstanden werden, welches innerhalb eines solchen Medienkammer strömen kann. Die fluiddichte Kapselung der jeweiligen Medienkammer gegen die äußere Umgebung wird dabei zumindest teilweise durch eine Außenwand des jeweiligen Untermodulgehäuses erreicht. So kann insbesondere der überwiegende Teil des Innenraums eines solchen Untermodulgehäuses in einem betriebsbereiten Zustand mit dem fluiden Kühlmittel ausgefüllt (geflutet) sein. Um unerwünschte elektrische Kontaktierungen der einzelnen Elemente eines solchen Untermoduls zu vermeiden, ist das fluide Kühlmittel elektrisch isolierend ausgebildet. Zum Beispiel kann hierfür eine dielektrische Flüssigkeit verwendet werden, ein elektrisch isolierendes Gas oder ein Dielektrikum, welches im Rahmen einer Zweiphasenkühlung beim Betrieb zwischen einem flüssigen und einem gasförmigen Zustand wechselt.

Bei der beschriebenen fluiddichten Kapselung des jeweiligen Modulgehäuses soll nicht ausgeschlossen sein, dass das betreffende Untermodul über Medienleitungen mit übrigen Untermodulen und/oder mit einem übergeordneten Medienzulauf und Medienablauf verbunden ist. Die Medienkammer soll aber (abgesehen von solchen Leitungen) von dem überwiegenden Teil der Umgebung des jeweiligen Untermoduls fluidisch getrennt sein. Auf diese Weise ist nicht der gesamte Innenraum des übergeordneten Gehäuses mit dem fluiden Kühlmittel geflutet, sondern nur die Innenräume einer Teilmenge der vorhandenen Untermodule. Es können auch alle enthaltenen Untermodule mit einem solchen Kühlmittel befüllt sein, dies ist aber nicht zwingend erforderlich. Die Zirkulation des fluiden Kühlmittels kann bevorzugt insgesamt innerhalb von ein oder mehreren geschlossenen Medienkreisläufen erfolgen. Auch dies ist jedoch nicht zwingend der Fall. Stattdessen kann die Zirkulation auch in einem sogenannten "offenen Kreislauf" erfolgen, bei welchem in einem übergeordneten Zulauf neues Kühlmedium zugeführt wird und in einem übergeordneten Ablauf benutztes Kühlmedium entfernt wird.

Wenigstens eines der mit dem fluiden Kühlmittel befüllten Untermodule ist so ausgestaltet, dass bei wenigstens einem enthaltenen elektrischen Element ein elektrisch aktiver Teilbereich von dem fluiden Kühlmittel angeströmt wird und zwar insbesondere im Wesentlichen direkt angeströmt wird. Ein solcher "elektrisch aktiver Teilbereich" kann beispielsweise ein Halbleiter, ein Kontakt, eine elektrische Verbindung (aus einem Leitermaterial) und/oder eine Elektrode sein. Beispielsweise kann der betreffende Teilbereich des elektrischen Elements in direktem Kontakt mit dem Inneren der Medienkammer für das zirkulierende Kühlmedium stehen. Auf diese Weise kann eine besonders effektive Entwärmung des jeweiligen elektrischen Elements erreicht werden, da der Wärmewiderstand eines zusätzlichen thermischen Kopplungselements (z.B. eines Kühlkörpers, eines Chipgehäuses, einer Platine und/oder einer Vergussmasse) hier entfällt. Es soll jedoch allgemein nicht ausgeschlossen sein, dass der elektrisch aktive Teilbereich durch eine dünne Schutzschicht von beispielsweise höchstens 200 µm Dicke und besonders vorteilhaft höchstens 100 µm Dicke von dem anströmenden Kühlmittel getrennt ist. So kann beispielsweise eine dünne Lackschicht oder Siliziumdioxidschicht oder ähnliches auf dem elektrisch aktiven Halbleiter- oder Leitermaterial vorliegen. Auch diese Ausführung soll also als "Anströmen" des entsprechenden Elements im Sinne der vorliegenden Erfindung verstanden werden.

Durch die elektrisch isolierende Eigenschaft des Kühlmittels wird eine unerwünschte zusätzliche Kontaktierung des Halbleitermaterials bzw. der Elektrode vermieden. Ein vollständiges "Umströmen" ist dabei nicht erforderlich, sondern ein "Anströmen" in einem Teilbereich des jeweiligen Halbleiters bzw. der jeweiligen Elektrode reicht aus. Bevorzugt ist aber ein wesentlicher Teil von einer der außenliegenden Hauptflächen des Halbleiters bzw. des Leitermaterials mit dem Kühlmittel anströmbar. Besonders vorteilhaft ist es, wenn wenigstens ein leistungselektronisches Schaltelement so ausgestaltet ist, dass das enthaltene Halbleitermaterial direkt von dem fluiden Kühlmedium angeströmt werden kann. Dies ist deshalb zweckmäßig, da die Bereiche des Leistungshalbleiters meist die Zonen mit der höchsten Verlustwärme (sogenannte "Hot Spots") in einem Stromrichter ausbilden. Weitere Hot Spots werden aber auch durch die Schaltungsanordnungen der Gate-Treiber und die Kondensatoren gebildet, so dass auch hier eine direkte Anströmung mit dem Kühlmittel vorteilhaft ist. Bei einem Kondensator ist es insbesondere vorteilhaft, wenn die außenliegenden Elektroden nicht von einer Vergussmasse umhüllt sind, sondern direkt von dem Kühlmittel angeströmt werden können. Dies können insbesondere die außenliegenden Elektroden eines Vielschichtkondensators bzw. die außenliegenden Teilbereiche der Elektroden eines gewickelten Kondensators sein. Allgemein kann auch eine Mehrzahl der vorhandenen elektrischen Elemente auf diese Weise direkt von dem Kühlmittel angeströmt werden.

Ein wesentlicher Vorteil des erfindungsgemäßen Stromrichtermoduls liegt darin, dass durch die direkte Anströmung mit dem fluiden Kühlmittel eine effektive Entwärmung derjenigen elektrischen Elemente möglich ist, die beim Betrieb eine besonders hohe Verlustleistung aufweisen. Dabei wird durch die auf der Untermodul-Ebene realisierte fluiddichte Kapselung trotzdem eine leichte Austauschbarkeit der einzelnen Untermodule erreicht. Der hohe apparative Aufwand eines insgesamt mit einem fluiden Kühlmittel gefluteten übergeordneten Gehäuses und die damit einhergehenden Einschränkungen in der Wartungsfreundlichkeit werden durch die Kapselung auf der Untermodul-Ebene vorteilhaft vermieden. Die Ausbildung einzelner elektrischer Funktionalitäten in räumlich getrennten Untermodulen ermöglicht dabei auch eine Kompatibilität von bereits bestehenden und neu entwickelten Komponenten eines Stromrichtermoduls. Beispielsweise können Untermodule mit höherer Leistungsdichte und/oder verbesserter Kühlung als Ersatz für herkömmliche luftgekühlte Untermodule bei der Einhaltung des vorgegebenen Bauraums und der vorgegebenen Schnittstellen zum Einsatz kommen. Die Modularität ermöglicht eine getrennte Optimierung des Kühlsystems (also z.B. der Strömungsverhältnisse und der thermischen Ankopplung der elektrischen Elemente an das Kühlmittel) im jeweiligen Untermodul. Für die einzelnen benötigten elektrischen Funktionalitäten des übergeordneten Stromrichters können standardisierte Untermodule zur Verfügung gestellt werden, die aus einem Baukastensystem zusammengestellt werden können. Dabei können insbesondere verschiedene Ausgestaltungen der Kühlsysteme der einzelnen Untermodule je nach thermischen und elektrischen Anforderungen miteinander kombiniert werden. Diejenigen Untermodule, die eine besonders hohe Fehleranfälligkeit aufweisen (z.B. diejenigen mit einer besonders hohen Verlustleistung) können dabei vorteilhaft an einer Peripherie angeordnet werden, also z.B. in einem Randbereich der Hauptplatine. So kann ein vergleichsweise leichter Austausch solcher besonders empfindlichen Untermodule ermöglicht werden.

Das erfindungsgemäße Verfahren dient zum Betrieb eines erfindungsgemäßen Stromrichtermoduls. Dabei wird das elektrisch isolierende Kühlmittel in wenigstens einem enthaltenen Untermodul so zirkuliert, dass es einen elektrisch aktiven Teilbereich eines elektrischen Elements des jeweiligen Untermoduls direkt anströmt. Diese Zirkulation kann insbesondere in einem insgesamt geschlossenen Medienkreislauf erfolgen. Die Vorteile des erfindungsgemäßen Verfahrens ergeben sich analog zu den oben beschriebenen Vorteilen des erfindungsgemäßen Stromrichtermoduls.

Vorteilhafte Ausgestaltungen und Weiterbildungen der Erfindung gehen aus den von den Ansprüchen 1 und 13 abhängigen Ansprüchen sowie der folgenden Beschreibung hervor. Dabei können die beschriebenen Ausgestaltungen des Stromrichtermoduls auch bei dem Betriebsverfahren realisiert werden, und umgekehrt.

So kann das Stromrichtermodul allgemein vorteilhaft als Umrichtermodul ausgestaltet sein, also insgesamt die Funktion eines Umrichters (AC/AC-Konverters) erfüllen. Solche Umrichter werden häufig im Rahmen der Antriebstechnik verwendet, um elektrische Maschinen (z.B. Drehstrommotoren) mit einer Wechselspannung zu versorgen. Mit solchen Umrichtern kann dabei die Frequenz und/oder Amplitude der generierten Wechselspannung angepasst werden, wodurch wichtige Regelparameter für den Betrieb von elektrischen Maschinen zur Verfügung gestellt werden können. Solche Umrichter finden Einsatz in vielfältigen Anwendungen (z.B. in der industriellen Antriebstechnik) und es besteht ein zunehmender Bedarf an Umrichtern mit hohen elektrischen Leistungen, hoher Regelungsfunktionalität und/oder kleinem Bauraum. Entsprechend kommen die Vorteile der Erfindung im Zusammenhang mit solchen Umrichtern (insbesondere Frequenzumrichtern) besonders wirksam zum Tragen. Allgemein und unabhängig von seiner speziellen Funktion kann das Stromrichtermodul wenigstens ein leistungselektronisches Schaltelement aufweisen, welches insbesondere als IGBT oder als Leistungs-MOSFET ausgestaltet ist. Dies sind typischerweise diejenigen elektrischen Elemente in einem Stromrichtermodul, welche als sogenannte "Hot Spots" besonders hohe Herausforderungen an eine effektive Entwärmung auf kleinem Raum mit sich bringen.

Das Kühlmedium kann vorteilhaft ein dielektrisches Öl sein. Dielektrische Öle sind elektrisch isolierende Öle, die z.B. aus der Hochspannungstechnik zur Isolation von Transformatoren bekannt sind. Entsprechend werden sie häufig auch als Transformatorenöle bezeichnet, insbesondere wenn sie schwer entzündlich und für den Betrieb bei höheren Temperaturen geeignet sind. Solche elektrisch isolierenden Öle sind auch zur direkten Anströmung der elektrisch aktiven Elemente eines Stromrichtermoduls geeignet, um diese bei Vermeidung unerwünschter elektrischer Kurzschlüsse zu entwärmen.

Allgemein bevorzugt kann das Gesamtvolumen des im Stromrichtermodul zirkulierenden Kühlmediums im Bereich zwischen 10 Millilitern und 5 Litern, bevorzugt zwischen 100 Millilitern und 5 Litern, liegen. Das genannte Gesamtvolumen kann dabei insbesondere die Summe aus den Teilvolumina für mehrere separate Teilkreisläufe darstellen. Falls solche fluidisch getrennten Teilkreisläufe vorliegen, können diese gleiche und/oder verschiedene Stoffe als Kühlmedien aufweisen. Allgemein und unabhängig von einer solchen möglichen Unterteilung ist ein Gesamtvolumen im genannten Bereich vorteilhaft, um einen effizienten Wärmetransport von den Bereichen mit den größten Verlustleistungen zum Außenbereich eines übergeordneten Stromrichtermoduls mit handelsüblichen Abmessungen zu bewirken. Mit einem derartigen Kühlmittelvolumen kann die freigesetzte Wärme insbesondere effizient über Strecken von mehreren Zentimetern bis mehreren zehn Zentimetern zu einem Außenbereich des übergeordneten Gehäuses hin abgeführt werden.

Gemäß einer weiteren vorteilhaften Ausführungsform kann im jeweiligen Untermodul das Untermodulgehäuse eine Untermodulplatine umschließen, welche die einzelnen elektrischen Elemente des jeweiligen Untermoduls trägt. Auf einer solchen Untermodulplatine können insbesondere die elektrischen Verbindungen der einzelnen elektrischen Elemente des jeweiligen Untermoduls realisiert sein. Bei dieser Ausführung werden die Medienkammern der einzelnen Untermodule durch die jeweiligen Untermodulgehäuse nach außen abgedichtet, und die einzelnen Untermodulplatinen befinden sich innerhalb dieser Medienkammern, insbesondere ohne Teil dieser Kapselung zu sein. So kann die jeweilige Untermodulplatine im Wesentlichen vollständig von fluidem Kühlmedium umspült werden, was eine besonders effektive Kühlung der darauf angeordneten elektrischen Elemente bewirkt. Es müssen jedoch nicht alle vorhandenen Untermodule auf diese Weise ausgestaltet sein, und es können insbesondere weitere Untermodule vorliegen, welche keine separate Untermodulplatine und/oder kein separates Untermodulgehäuse aufweisen. Zusätzlich zu den genannten Untermodulplatinen kann das Stromrichtermodul vorteilhaft eine Hauptplatine aufweisen, welche die einzelnen Untermodule trägt und durch welche die elektrischen Verbindungen zwischen den einzelnen Untermodulen realisiert sind.

Gemäß einer weiteren Ausgestaltung der Erfindung kann zumindest eine erste Teilmenge der Untermodule so ausgestaltet sein, dass ihre jeweiligen Medienkammern durch die zugeordneten Untermodulgehäuse vollständig nach außen hin gekapselt sind. Mit anderen Worten bilden diese Untermodule der ersten Teilmenge dann fluidisch gesehen jeweils separate Inseln aus, und ihre Medienkammern sind insbesondere nicht über Medienleitungen mit einem übergeordneten Medienkreislauf verbunden. Insbesondere liegen für die Untermodule der ersten Teilmenge gar keine äußeren Kühlmittelanschlüsse vor. Diese separat gekapselte Ausführung erlaubt einen besonders einfachen Ersatz von herkömmlichen luftgekühlten Untermodulen durch elektrisch kompatible Untermodule mit einem internen Kühlmittelkreislauf, ohne dass hierfür äußere Anschlüsse vorgesehen werden müssen. So kann in einem bestehenden Design für ein Stromrichtermodul besonders leicht ein Upgrade auf eine neue Produktversion mit z.B. höherer Leistungsdichte und/oder zuverlässigerer Kühlung vorgenommen werden, indem ein oder mehrere einzelne Untermodule gegen verbesserte Untermodule nach dem Prinzip der vorliegenden Erfindung ausgetauscht werden. So können abwärtskompatible Untermodule zum Austausch gegen luftgekühlte Untermodule von herkömmlichen Stromrichtermodulen zur Verfügung gestellt werden. Die Untermodule der beschriebenen ersten Teilmenge sind außerdem besonders wartungsfreundlich, da sie im Rahmen eines Fehlerfalls leicht einzeln ausgetauscht werden können. Gemäß einer Variante dieser Ausführungsform können insbesondere alle vorliegenden Untermodulgehäuse vollständig gekapselte und fluidisch voneinander getrennte Medienkammern ausbilden.

Alternativ oder zusätzlich zu der vorab beschriebenen einzelnen Kapselung können einzelne Untermodule jedoch prinzipiell auch zugeordnete Medienanschlüsse für das Kühlmedium aufweisen, insbesondere jeweils einen Medienzulauf und einen Medienablauf, um die einzelnen Untermodule mit einem übergeordneten Medienkreislauf zu verbinden. Ein solcher übergeordneter Medienkreislauf kann sich über eine Mehrzahl von solchen Untermodulen erstrecken und sich prinzipiell auch auf einen Bereich außerhalb des übergeordneten Gehäuses des gesamten Stromrichtermodul erstrecken, z.B. wenn eine außenliegende Pumpe zur Zirkulation verwendet wird.

Allgemein und unabhängig von einem Vorhandensein von Medienanschlüssen für die einzelnen Untermodule können die einzelnen Medienkammern der Untermodule einer Mehrzahl von fluidisch voneinander getrennten Gruppen zugeordnet sein. Mit anderen Worten kann das übergeordneten Stromrichtermodul eine Mehrzahl von fluidisch getrennten Medienkreisläufen aufweisen, denen die Untermodule einzeln bzw. gruppenweise angehören können. Die fluidisch getrennten Gruppen können also insbesondere jeweils ein oder mehrere Medienkammern umfassen. Die einzelnen fluidisch getrennten Gruppen können sich vorteilhaft bezüglich ein oder mehrerer Betriebsparameter beim Betrieb ihres zugeordneten Medienkreislaufs unterscheiden. Dies können insbesondere ein oder mehrere der folgenden Parameter sein:
- eine chemischen Zusammensetzung des enthaltenen Kühlmediums,
- eine Anzahl von während der Zirkulation auftretenden Aggregatzuständen des Kühlmediums,
- eine Art des Strömungsantriebs für einen jeweils zugeordneten Medienkreislauf,
- eine innerhalb eines jeweils zugeordneten Medienkreislaufs beim Betrieb auftretende Maximaltemperatur des Kühlmediums, wobei der Unterschied insbesondere bei wenigstens 10 °C liegt.

Ein derartiger Unterschied in den Betriebsparametern der lokalen Kühlmittelkreisläufe in den einzelnen fluidisch getrennten Gruppen kann dazu beitragen, für einzelne Teilbereiche des Stromrichtermoduls jeweils lokal eine ressourcenoptimierte Kühlung vorzusehen, welche insbesondere auf die tatsächlich im jeweiligen Teilbereich freigesetzte Verlustleistung angepasst ist. So können beispielsweise in den einzelnen Medienkreisläufen unterschiedliche Kühlmedien zum Einsatz kommen. So kann es vorteilhaft sein, für ein Leistungsmodul mit leistungselektronischen Schaltelementen, die beim Betrieb besonders heiß werden, ein anderes Kühlmittel vorzusehen als für ein Kondensatormodul, dessen Kondensatoren zwar auch warm werden, aber nicht ganz so heiß wie die Schaltelemente.

Allgemein kann in wenigstens einer solchen Gruppe ein Medienkreislauf mit einer Zweiphasenkühlung vorliegen, und in wenigstens einer anderen Gruppe kann ein Medienkreislauf mit einer Einphasenkühlung vorliegen. Beispielsweise kann ein Untermodul oder eine Gruppe von Untermodulen mit einer besonders großen Verlustleistung durch eine Zweiphasenkühlung wie bei einem Wärmerohr oder einer Thermosiphonkühlung besonders effizient gekühlt werden, während bei anderen Untermodulen mit einer niedrigeren Verlustleistung eine apparativ einfacher zu realisierende Einphasenkühlung (z.B. mit einem Kreislauf eines flüssigen Kühlmediums) ausreichen kann. In ähnlicher Weise kann ein Medienkreislauf für eine erste fluidisch getrennte Gruppe von Untermodulen passiv angetrieben werden (wie z.B. bei einem Wärmerohr oder einem Thermosiphon), während ein Medienkreislauf für eine zweite fluidisch getrennte Gruppe aktiv mit einer oder mehreren Pumpen oder anderen bewegten Elementen angetrieben werden kann. Durch derart unterschiedliche Betriebsparameter der einzelnen Kühlkreisläufe und/oder durch unterschiedliche Verlustleistungen in den einzelnen Gruppen von Untermodulen können sich insbesondere auch deutlich unterschiedliche Temperaturniveaus in den getrennt zirkulierenden Kühlmitteln einstellen.

Allgemein und unabhängig von den vorgesehenen Betriebsparametern des jeweiligen Medienkreislaufs kann das Stromrichtermodul eine zweite Teilmenge von Untermodulen aufweisen, deren Medienkammern mittels eines Leitungssystems fluidisch miteinander gekoppelt sind. Mit anderen Worten gehören dann zwei oder mehr Untermodule der zweiten Teilmenge zusammen einer fluidisch abgetrennten Gruppe an. Diese Gruppe kann entweder das einzige fluidisch gekapselte System ausbilden oder es können - wie oben beschrieben - mehrere solche fluidisch getrennten Systeme vorliegen, die zum Teil aus nur auch einzelnen Untermodulen bestehen können. Die Ausbildung von fluidisch miteinander gekoppelten Untergruppen kann allgemein vorteilhaft sein, um durch eine Zirkulation des fluiden Kühlmediums über einen größeren Teilbereich des Stromrichtermoduls eine besonders effiziente Wärmespreizung zu erreichen. So kann z.B. die Abwärme aus Untermodulen mit besonders hoher Verlustleistung über eine solche koppelnde Medienleitung in Bereiche von anderen Untermodulen transportiert werden, bei denen mehr Fläche zur Anordnung von Kühlkörpern zur Verfügung steht. Weiterhin kann bei einer gemeinsamen Zirkulation des Kühlmittels durch mehrere Untermodule ein Strömungsantrieb (z.B. in Form einer oder mehrerer Pumpen) besonders effizient genutzt werden.

Allgemein können auch mehrere solche Untergruppen von fluidisch miteinander gekoppelten Untermodulen vorliegen, so dass dann insbesondere in analoger Weise eine optionale dritte Teilmenge, vierte Teilmenge usw. ausgebildet ist. Diese Mehrzahl der voneinander fluidisch getrennten Gruppen kann sich insbesondere bezüglich der Betriebsparameter der jeweiligen Kühlmittel-Zirkulation voneinander unterscheiden, wie oben beschrieben.

Gemäß einer vorteilhaften Weiterbildung der Ausführungsform mit fluidisch gekoppelten Untermodulen kann zumindest ein Teil der Untermodule der zweiten Teilmenge in parallel zueinander verlaufenden Strömungszweigen eines übergeordneten geschlossenen Medienkreislaufs liegen. Mit anderen Worten kann sich der Medienkreislauf an wenigstens einer Stelle verzweigen, und die dadurch gebildeten parallelen Strömungszweige können an einer oder mehreren Stellen zusammenlaufen. So ist über eine Mehrzahl von Untermodulen ein Medienkreislauf mit einer komplexen Topologie gebildet, was eine noch genauere Anpassung der Kühlung an die lokal dissipierte Verlustleistung erlaubt. Insbesondere kann bei der Ausführungsform mit parallel liegenden Strömungszweigen eine einfache Durchflussregelung durch die einzelnen Strömungszweige umgesetzt werden.

Allgemein und unabhängig von der Topologie der Medienkammern kann das Stromrichtermodul ein Element zur bedarfsabhängigen Anpassung der Strömung des Kühlmediums durch wenigstens eines der vorhandenen Untermodule aufweisen. Eine solche bedarfsabhängige Anpassung kann in einer besonders einfach umzusetzenden Ausführung bereits durch einen sogenannten Temperaturschalter (z.B. einen Bimetallschalter) erreicht werden, welcher in Abhängigkeit von der Temperatur seinen Schaltzustand ändert. In Abhängigkeit von einer solchen temperaturabhängigen Schalterstellung kann beispielsweise eine Pumpe angetrieben und/oder ein Strömungsventil geöffnet oder geschlossen werden.

Allgemein kann das Stromrichtermodul eine Regeleinrichtung umfassen, welche zur automatisierten Regelung eines Durchflusses des fluiden Kühlmediums durch die Medienkammern der einzelnen Untermodule ausgelegt ist. Eine solche Durchflussregelung ist insbesondere in Kombination mit einem aktiven Strömungsantrieb (z.B. mit einer Pumpe) wirkungsvoll und leicht umzusetzen. Beispielsweise kann der Pumpleistung einer Pumpe geregelt werden und/oder der Durchfluss durch ein in der Medienleitung angeordnetes Ventil kann geregelt werden, um insbesondere die Stärke der Kühlmittelströmung durch ein oder mehrere Untermodule gezielt einstellen zu können und so die Wärmeabfuhr aus diesen Untermodulen zu regeln. Die Regeleinrichtung kann also allgemein einen Aktor umfassen, mit welchem z.B. die Leistung einer Pumpe oder eine Ventilstellung beeinflusst werden kann.

Gemäß einer besonders vorteilhaften Weiterbildung dieser Ausführungsform weist das Stromrichtermodul wenigstens eine Steuereinheit zur automatisierten Ansteuerung der wenigstens einen Regeleinrichtung auf. Diese Steuereinheit kann auch Teil der Regeleinrichtung sein. Außerdem weist es wenigstens ein Sensorelement auf, um ein Messsignal als Grundlage für eine Durchflussregelung mittels der Steuereinheit zur Verfügung zu stellen. Gemäß der entsprechenden Ausführungsform des Verfahrens wird der Durchfluss mittels der Steuereinheit auf Basis des vom Sensorelement erhaltenen Messsignals automatisiert geregelt. Das Sensorelement kann beispielsweise ein Temperatursensor sein, und der Durchfluss kann somit temperaturabhängig geregelt werden. So kann insbesondere eine Pumpleistung oder eine Ventilstellung in Reaktion auf einen gemessenen Temperaturwert angepasst werden, um eine Kühlung ein oder mehrerer elektrischer Elemente auf einen vorgegebenen Temperaturbereich zu gewährleisten. Insbesondere wenn die Verlustleistungen der einzelnen im Stromrichtemodul enthaltenen elektrischen Elemente nicht konstant sind, sondern zeitlichen Schwankungen unterworfen sind, kann eine solche Regelung nützlich sein, um einen Kühlmittelstrom gezielt dorthin zu leiten, wo die meiste Kühlleistung benötigt wird. Dies kann besonders wirksam bei der oben beschriebenen Ausführungsform mit mehreren parallel liegenden Strömungszweigen erreicht werden, da hierbei eine gezielte Verstärkung der Medienströmung in den besonders heißen Untermodulen ermöglicht wird. Alternativ zu einem Temperaturwert kann das einer solchen Regelung zugrundeliegende Messsignal aber auch beispielsweise ein gemessener elektrischer Strom-, Spannungs- und/oder Leistungswert oder ein anderer physikalischer Parameter sein.

Allgemein und unabhängig von den zugrundeliegenden Mess- und Regelungsgrößen kann die beschriebene Durchflussregelung von einer automatisierten, computergestützten Regelungseinrichtung umgesetzt werden. Mit anderen Worten kann ein intelligentes, computergestütztes Thermomanagementsystem zum Einsatz kommen, welches den lokalen Durchfluss des Kühlmediums bedarfsgerecht regelt. So kann eine besonders ressourceneffiziente Kühlung der einzelnen Bauelemente erreicht werden. Ein solches Thermomanagementsystem kann insbesondere ein selbstlernendes System sein, bei welchem Methoden der künstlichen Intelligenz zum Einsatz kommen.

Gemäß einer weiteren allgemein vorteilhaften Ausführungsform weist das Stromrichtermodul wenigstens einen geschlossenen Medienkreislauf für ein fluides Kühlmedium auf, welcher vollständig innerhalb des übergeordneten Gehäuses liegt. Besonders vorteilhaft können sogar alle vorhandenen Medienkreisläufe vollständig innerhalb des Gehäuses des Stromrichtermoduls liegen. Bei dieser Ausführungsform werden durch die erfindungsgemäße Ausführung der Kühlung keine Medienanschüsse für den Kühlkreislauf im Bereich des übergeordneten Gehäuses hinzugefügt. Vorteilhaft weist das übergeordnete Gehäuse daher gar keine nach außen führenden Medienleitungen für ein fluides Kühlmittel auf. Durch eine solche nach außen hin "leitungsfreie" Ausführung des Stromrichtermoduls kann eine Kompatibilität der Schnittstellen mit einem herkömmlichen luftgekühlten Stromrichtermodul erreicht werden. Auf diese Weise kann eine besonders leichte Austauschbarkeit von herkömmlichen gegen erfindungsgemäße Stromrichtermodule, z.B. in einer industriellen Anlage erreicht werden.

Alternativ zu einer solchen fluidleitungsfreien Ausführung kann das übergeordnete Gehäuse des Stromrichtermoduls jedoch auch ein oder mehrere Medienanschlüsse aufweisen. Bevorzugt liegen für ein oder mehrere der vorhandenen Medienkreislaufe (also der vorhandenen fluidisch abgeschlossenen Gruppen) jeweils zwei außenliegende Medienanschlüsse vor, nämlich pro von außen gespeister Gruppe ein Medienzulauf und ein Medienablauf. Dabei muss jedoch nicht jede der vorhandenen fluidisch abgeschlossenen Gruppen solche äußeren Medienanschlüsse aufweisen. Vielmehr kann eine Teilmenge der fluidisch abgeschlossenen Gruppen auch (wie im vorhergehenden Absatz beschrieben) einen vollständig innerhalb des Gehäuses liegenden Medienkreislauf aufweisen. Allgemein kann ein solcher vollständig innenliegender Medienkreislauf beispielsweise einen passiven Strömungsantrieb aufweisen oder mit einer innerhalb des übergeordneten Gehäuses liegenden Kühlmittelpumpe angetrieben werden.

Allgemein vorteilhaft kann das Stromrichtermodul wenigstens einen Kühlkörper und/oder Wärmeübertrager umfassen. Ein solcher Kühlkörper bzw. Wärmeübertrager ist insbesondere so ausgestaltet, dass er von dem fluiden Kühlmedium anströmbar ist und zur Abgabe von Wärme an eine Umgebung des Stromrichtermoduls ausgelegt ist. Allgemeiner ausgedrückt kann das Stromrichtermodul ein sekundäres Kühlelement aufweisen, dass zur Aufnahme von Wärme aus dem fluiden Kühlmedium ausgelegt ist und zur Abgabe von Wärme an die äußere Umgebung des Stromrichtermoduls ausgelegt ist. Dazu kann das sekundäre Kühlelement von dem fluiden Kühlmedium angeströmt werden. Das sekundäre Kühlelement kann beispielsweise in einem Außenbereich des Stromrichtermoduls angeordnet sein und insbesondere von einer Außenwand des Gehäuses getragen werden oder in eine solche Außenwand integriert sein. Alternativ kann ein solches sekundäres Kühlelement jedoch auch im Bereich der Gehäusewand eines Untermodulgehäuses angeordnet sein oder an anderer Stelle im Innenraum des übergeordneten Modulgehäuses positioniert sein. Das sekundäre Kühlelement kann besonders bevorzugt von dem fluiden Kühlmittel durchströmt werden. Mit anderen Worten kann es ein oder mehrere innenliegende Medienkanäle aufweisen, die Teil des Medienkreislaufs für das fluide Kühlmittel sind.

Gemäß einer ersten Ausführungsvariante kann das sekundäre Kühlelement ein Kühlkörper sein, insbesondere ein Kühlkörper, der in einem von dem Medienraum des fluiden Kühlmittels abgewandten Bereich eine oberflächenvergrößernde Struktur aufweist. Diese Struktur vergrößert die Oberfläche im Vergleich zu einer ebenen Oberfläche und bewirkt so eine Erhöhung der Wärmeabgabe des Kühlkörpers an die Umgebung, beispielsweise an eine Umgebungsluft oder ein weiteres, den Kühlkörper anströmendes fluides Kühlmedium. Die oberflächenvergrößernde Struktur kann insbesondere eine Mehrzahl von Kühlrippen aufweisen bzw. aus solchen Kühlrippen bestehen. Alternativ oder zusätzlich können auch andere oberflächenvergrößernde Strukturen wie Kühlsterne, Kühlfahnen, Kühlsäulen und/oder sogenannte Pin Fins zum Einsatz kommen.

Gemäß einer alternativen Ausführungsvariante kann das Kühlelement ein Wärmeübertrager oder ein thermisch koppelndes Element eines Wärmeübertragers sein. Solche Wärmeübertrager werden manchmal auch als Wärmetauscher bezeichnet und ermöglichen die Übertragung von thermischer Energie von einem Stoffstrom auf einen anderen, hier also von dem fluiden Arbeitsmedium des beschriebenen Medienkreislaufs auf ein weiteres fluides Kühlmedium. Dieses weitere fluide Kühlmedium kann eine von dem Medienraum abgewandte Seite des Kühlelements anströmen und prinzipiell in einem geschlossenen Kreislauf zirkulieren oder in einer offenen Strömung dort entlanggeführt werden. Der Wärmeübertrager kann beispielsweise zu einem Betrieb nach dem Gegenstromprinzip, nach dem Gleichstromprinzip oder nach dem Kreuzstromprinzip ausgelegt sein.

Gemäß einer vorteilhaften Weiterbildung des Verfahrens kann ein Durchfluss des fluiden Kühlmediums durch einzelne Teilbereiche des Medienkreislaufs sensorabhängig und insbesondere temperaturabhängig geregelt werden. Hierzu weist das Stromrichtermodul wenigstens einen Temperatursensor auf und/oder einen Sensor für eine andere physikalische Eigenschaft, welche insbesondere mit einer Temperatur innerhalb des Stromrichtermoduls zusammenhängt. Die so (direkt oder indirekt) gemessene Temperatur kann insbesondere eine Temperatur im Bereich eines der vorhandenen Untermodule sein.

Gemäß einer weiteren vorteilhaften Ausgestaltung kann das Stromrichtermodul wenigstens einen Lüfter zur Förderung einer Luftzirkulation durch das übergeordnete Gehäuse aufweisen. Die Kühlung des Stromrichtermoduls basiert dann also auf einem hybriden Ansatz, wobei sowohl eine Luftkühlung des übergeordneten Gehäuses als auch eine lokale Entwärmung im Bereich der einzelnen Untermodule mittels des fluiden (und insbesondere flüssigen) Arbeitsmediums zum Einsatz kommen. Diese Ausgestaltung ist besonders vorteilhaft in Kombination mit der Verfahrensvariante, bei der die beschriebene Durchflussregelung zum Einsatz kommt. Besonders vorteilhaft wird dann mittels einer Steuervorrichtung sowohl der Durchfluss des fluiden Arbeitsmediums durch die Untermodule als auch der Luftdurchsatz des Lüfters durch das übergeordnete Gehäuse automatisiert geregelt. Diese Regelung kann insbesondere sensorabhängig erfolgen, also beispielsweise in Abhängigkeit von einer gemessenen elektrischen Leistung, einer gemessenen Temperatur oder einem anderen physikalischen Parameter, aus welchem ein Bedarf für die Entwärmung abgeleitet werden kann. Unter dem Begriff "Steuern" soll hier allgemein auch ein "Regeln" mit umfasst sein.

Das Stromrichtermodul kann allgemein vorteilhaft wenigstens einen Sensor aufweisen. Ein solcher Sensor kann wie oben beschrieben, zur Durchflussregelung verwendet werden. Alternativ oder zusätzlich kann ein Sensor vorliegen, welcher zur Erkennung eines Leckzustandes in einem oder mehreren der vorliegenden Medienkreisläufe ist. Ein solcher Lecksensor kann beispielsweise ein Drucksensor zur Erkennung eines Druckabfalls in einer Medienleitung oder ein Feuchtigkeitssensor zur Erkennung von unerwünschtem fluiden Kühlmittel sein, welches aufgrund eines Lecks in Bereiche des Stromrichtermoduls dringt, welche nicht Teil des beabsichtigten Medienkreislaufs sind. Gemäß einer vorteilhaften Weiterbildung des Verfahrens kann das Stromrichtermodul immer dann abgeschaltet werden, wenn ein mittels eines solchen Sensors ein Leckzustand erkannt wird, also wenn der Sensor ein Signal liefert, welches charakteristisch für einen Leckzustand ist. Ein solcher Sicherheitsmechanismus kann z.B. einen unerwünschten Weiterbetrieb verhindern, wenn aufgrund eines Lecks eine ausreichende Kühlung nicht mehr sichergestellt werden kann. Weiterhin kann die Abschaltung aber auch aus Sicherheitsgründen zweckmäßig sein, wenn das herausleckende Kühlmedium ein Sicherheitsrisiko beim Betrieb der übrigen Komponenten des Stromrichtermoduls darstellt. Dies ist insbesondere dann der Fall, wenn (alternativ oder zusätzlich zu dem oben erwähnten dielektrischen Fluid) ein elektrisch leitendes fluides Kühlmedium zum Einsatz kommt. Andere Sicherheitsrisiken können aber auch von korrosiven Kühlmedien ausgehen, so dass eine solche Leckerkennung auch im Zusammenhang mit dielektrischen Fluiden zweckmäßig sein kann.

Nachfolgend wird die Erfindung anhand einiger bevorzugter Ausführungsbeispiele unter Bezugnahme auf die angehängten Zeichnungen beschrieben, in denen:
- Figur 1: ein Stromrichtermodul nach einem ersten Beispiel der Erfindung im schematischen Querschnitt zeigt,
- Figur 2: ein ähnliches Stromrichtermodul mit fluidisch gekoppelten Untermodulen zeigt,
- Figur 3: ein ähnliches Stromrichtermodul mit einer außenliegenden Kühlmittelpumpe und mehreren Kühlkörpern zeigt und
- Figur 4: ein ähnliches Stromrichtermodul mit parallelen Strömungszweigen und einer automatisierten Durchflussregelung zeigt.

In den Figuren sind gleiche oder funktionsgleiche Elemente mit gleichen Bezugszeichen versehen.

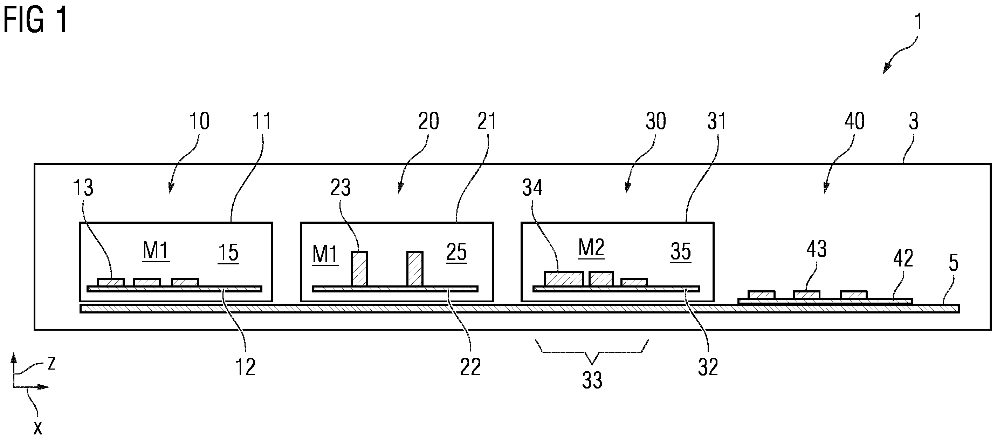

In Figur 1 ist ein Stromrichtermodul 1 nach einem ersten Beispiel der Erfindung im schematischen Querschnitt gezeigt. Dieses Stromrichtermodul 1 kann beispielsweise ein Umrichtermodul sein, insbesondere mit der Funktionalität eines Frequenzumrichters, zur Bereitstellung einer in Amplitude und Frequenz einstellbaren Wechselspannung für eine Antriebsvorrichtung. Das Stromrichtermodul 1 weist ein außenliegendes Modulgehäuse 3 auf, innerhalb dessen die wesentlichen funktionalen elektrischen Elemente angeordnet sind. Der innere Aufbau des Stromrichtermoduls 1 ist insgesamt modular, d.h. es liegt eine Mehrzahl von Untermodulen vor, die jeweils eine ihnen zugeordnete spezifische elektrische Funktion erfüllen können. Beispielhaft sind hier vier solche Untermodule 10, 20, 30 und 40 dargestellt, die jeweils über eine Hauptplatine 5 elektrisch miteinander verbunden sind. Der gezeigte Schnitt ist ein Schnitt durch die xz-Ebene, wobei die x-Achse eine der beiden sogenannten lateralen Raumrichtungen (parallel zu einer Hauptebene der Hauptplatine 5) darstellt und die z-Achse eine sogenannte vertikale Raumrichtung (orthogonal zu einer Hauptebene der Hauptplatine 5) darstellt.

Das erste Untermodul 10 ist hier beispielsweise ein Leistungsmodul, welche eine Mehrzahl von leistungselektrischen Schaltelementen 13 enthält. Daneben kann es natürlich auch noch weitere, hier nicht separat dargestellte elektrische Elemente aufweisen, insbesondere Leitungen, elektrische Widerstände und ähnliches. Das erste Untermodul 10 weist ein zugeordnetes erstes Untermodulgehäuse 11 auf, welches die zugeordneten elektrischen Elemente 13 umschließt. Die elektrischen Elemente 13 dieses ersten Untermoduls werden von einer ersten Untermodulplatine 12 getragen, welche ebenfalls im Inneren des Untermodulgehäuses 11 angeordnet ist. Durch den Innenraum des ersten Untermodulgehäuses 11 ist eine erste Medienkammer 15 ausgebildet, in welcher ein erstes fluides Kühlmedium M1 zirkulieren kann, beispielsweise ein dielektrisches Öl. Der Innenraum des ersten Untermoduls 10 kann also im Wesentlichen mit diesem ersten Kühlmedium M1 geflutet sein. Durch das erste Untermodulgehäuse 11 ist diese erste Medienkammer 15 so gegen die äußere Umgebung gekapselt, dass die umgebenden Bereiche des Stromrichtermodul 1 nicht von diesem Kühlmedium M1 geflutet werden. Im Bereich außerhalt der einzelnen Untermodule 10 bis 40 enthält das übergeordnete Gehäuse 3 des Stromrichtermoduls 1 also beispielsweise Luft.

Das erste Kühlmedium M1 kann innerhalb der ersten Medienkammer 15 beispielsweise durch Konvektion bewegt werden. Alternativ kann jedoch innerhalb der ersten Medienkammer auch ein ringförmiger Medienkanal ausgebildet sein, in welchem sich eine Zirkulation in einem geschlossenen Kreislauf, insbesondere mit einer Vorzugsrichtung, ausbilden kann. Eine solche Zirkulation kann beispielsweise durch eine Pumpe, durch einen Thermosiphon-Effekt (also mittels der Schwerkraft) oder durch das Wirkprinzip eines Wärmerohrs (also durch kapillar getriebenen Fluidtransport) angetrieben werden.

Die erste Medienkammer 15 ist so ausgestaltet, dass Kühlmedium M1 des ersten Untermoduls 10 in unmittelbaren Kontakt mit einem Halbleitermaterial der leistungselektrischen Schaltelemente 13 treten kann. Dieses Halbleitermaterial ist also von dem Kühlmedium M1 direkt anströmbar. Dies wird dadurch erreicht, dass der Innenraum des ersten Modulgehäuses 11 im Wesentlichen vollständig mit dem Kühlmedium M1 geflutet ist und dass das Halbleitermaterial der einzelnen Schaltelemente 13 nicht durch eine Vergussmasse oder ein lokales Chipgehäuse gegen das Kühlmedium M1 gekapselt ist. Das Halbleitermaterial von wenigstens einem der Schaltelemente 13 liegt also innerhalb des Untermodulgehäuses 11 unverkapselt vor. Durch eine solche direkte Anströmung mit dem Kühlmedium kann eine besonders effektive Entwärmung lokaler Hot Spots bewirkt werden.

Das zweite Untermodul 20 ist hier ein Kondensatormodul, welches ein oder mehrere elektrische Kondensatoren 23 aufweist, von denen hier nur zwei beispielhaft gezeigt sind. Auch diese Kondensatoren 23 sowie gegebenenfalls weitere elektrische Elemente sind hier auf einer Untermodulplatine 22 angeordnet und auf dieser elektrisch kontaktiert. Ähnlich wie das erste Untermodul 10 weist auch das zweite Untermodul 20 ein fluidisch gegen die äußere Umgebung gekapseltes Untermodulgehäuse 21 auf, in dessen Innenraum eine Medienkammer 25 für ein fluides Kühlmedium M1 ausgebildet ist. Diese zweite Medienkammer 25 ist hier mit demselben Kühlmedium M1 befüllt wie die erste Medienkammer 15. Die elektrischen Kondensatoren 23 liegen hier jeweils als unverkapselte Kondensatorwickel vor, deren außenliegende Elektrode ähnlich wie das Halbleitermaterial des ersten Untermoduls 10 direkt von dem fluiden Kühlmedium M1 anströmbar ist.

Das dritte Untermodul 30 ist hier ein Treibermodul, welches eine Gate-Treiber-Schaltungsanordnung zur Ansteuerung der Gate-Elektroden der einzelnen Schaltelemente 13 des Leistungsmoduls 10 aufweist. Diese Gate-Treiber-Schaltungsanordnung ist hier insgesamt mit 33 bezeichnet und weist mehrere elektrische Teilelemente 34 auf, z.B. eine Mehrzahl von Widerständen, Transistoren, Dioden, Verstärkern und ähnlichem. Diese Schaltung kann insbesondere durch einen integrierten Schaltkreis (also auf einem Halbleiterchip) oder durch eine Mehrzahl von einzelnen Bauelementen realisiert sein. Auch hier sind die einzelnen Teilelemente 34 auf einer zugeordneten Untermodulplatine 23 angeordnet und werden innerhalb von einem fluidisch gekapselten Untermodulgehäuse 31 (also in einer dritten Medienkammer 35) von einem fluiden Kühlmedium M2 umströmt. Bei diesem dritten Untermodul 30 wird ein von dem ersten Kühlmedium unterschiedliches Kühlmedium M2 eingesetzt. Beispielsweise kann hier ein Kühlmedium mit einer niedrigeren Temperaturbeständigkeit gewählt werden, falls die Betriebstemperatur der Schaltungsanordnung 33 deutlich niedriger liegt als die Betriebstemperatur der Schaltelemente 13 bzw. der Kondensatoren 23.

Nur der Vollständigkeit halber ist hier ein viertes Untermodul 40 gezeigt, welches nicht wie die anderen Untermodule 10 bis 30 durch ein zugeordnetes Untermodulgehäuse gegen den übrigen Innenraum des Stromrichtermoduls 1 gekapselt ist. Entsprechend liegen die elektrischen Elemente 43 innerhalb des übergeordneten Gehäuses 3 frei und können dort z.B. von der innenliegenden Luft gekühlt werden. Dieses vierte Untermodul 40 soll nur verdeutlichen, dass nicht alle elektrischen Elemente auf die beschriebene Weise in fluidisch gekapselten Untermodulen vorliegen müssen, sondern dass auch herkömmlich gekühlte Elemente im Stromrichtermodul vorhanden sein können. Es können auch Untermodule mit zugeordneten Untermodulgehäusen zum Einsatz kommen, deren Innenraum nicht gegen die äußere Umgebung gekapselt ist und die z.B. mit Luft gefüllt sind. Auch die hier dargestellte vierte Untermodulplatine 42 ist allgemein optional, und die elektrischen Elemente 43 des vierten Untermoduls 40 könnten auch direkt auf der Hauptplatine angeordnet sein oder auf andere Weise elektrisch mit den weiteren Untermodulen 10 bis 30 verbunden sein.

Bei den ersten drei Untermodulen 10, 20 und 30 wird eine Entwärmung der enthaltenen elektrischen Elemente 13, 23 bzw. 33 dadurch erreicht, dass mittels des jeweils darin zirkulierenden Kühlmediums M1 bzw. M2 eine Wärmeübertragung auf das jeweilige Untermodulgehäuse 11, 21 bzw. 31 erfolgt. Von hier aus kann beispielsweise eine weitere Wärmeübertragung an eine im Innenraum des übergeordneten Gehäuses 3 zirkulierende Luft erfolgen, so dass die Wärme insgesamt an die Umgebungsluft abgegeben werden kann. Um diese Luftzirkulation zu fördern, kann das übergeordnete Stromrichtermodul 1 optional mit einem hier nicht näher dargestellten Lüfter ausgestaltet sein.

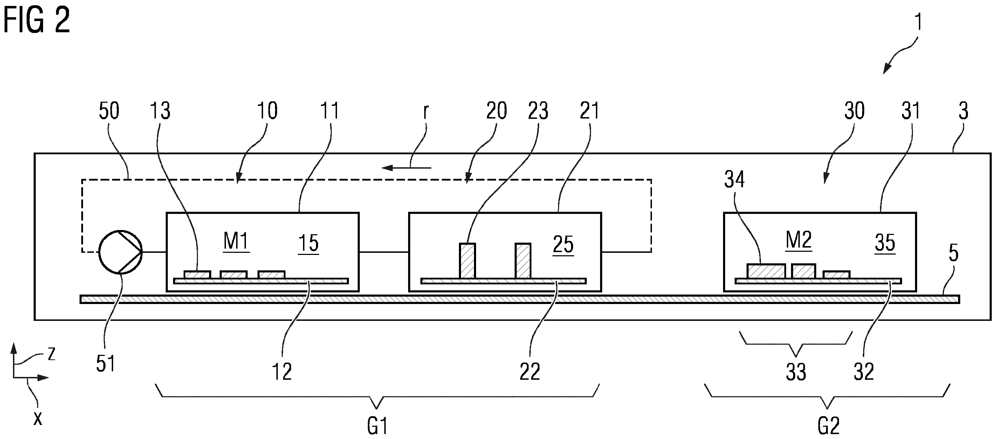

In Figur 2 ist ein Stromrichtermodul 1 nach einem zweiten Beispiel der Erfindung im vergleichbaren schematischen Querschnitt gezeigt. Das Stromrichtermodul 1 ist insgesamt ähnlich aufgebaut wie beim ersten Ausführungsbeispiel, hier sind jedoch der Übersichtlichkeit halber nur die ersten drei Untermodule 10 bis 30 gezeigt. Der wesentliche Unterschied zum Beispiel der Figur 1 ist, dass die beiden Untermodule 10 und 20 hier durch ein Leitungssystem 50, also eine Medienleitung, zu einer fluidisch gekoppelten Gruppe G1 zusammengeschlossen sind. Im Unterschied zu den Medienkammern 15 und 25 der Figur 1 weisen die Medienkammern 15 und 25 dieses Ausführungsbeispiels also jeweils einen Medienzulauf und einen Medienablauf auf. Diese Medienzuläufe und -abläufe bilden also zusätzliche fluidische Schnittstellen des jeweiligen Untermodulgehäuses 11 und 21 aus. Im Unterschied zum vorhergehenden Beispiel und auch im Unterschied zum dritten Untermodul 30 sind diese Untermodulgehäuse 11 und 21 also nicht vollständig nach außen hin gekapselt, sondern die Kapselung wird durch die Medienleitung 50 lokal unterbrochen.

Das gesamte Leitungssystem 50 der Medienleitung bildet hier einen ringförmig geschlossenen Medienkreislauf aus. Dieses ringförmig geschlossene Leitungssystem 50 muss nicht vollständig innerhalb der Schnittebene liegen, was hier durch die gestrichelt gezeigte Rückleitung angedeutet ist. Insgesamt ergibt sich eine bevorzugte Strömungsrichtung r über das ringförmige Leistungssystem. Dies kann prinzipiell entweder durch einen passiven Strömungsantrieb nach dem Prinzip eines Wärmerohrs oder Thermosiphons oder wie in diesem Beispiel durch einen aktiven Strömungsantrieb, z.B. mit einer Pumpe 51 erreicht werden. Auch bei einer solchen fluidisch gekoppelten Gruppe G1 ist also solch ein aktives Antriebselement 51 allgemein optional.

Ähnlich wie beim ersten Ausführungsbeispiel finden sich in den beiden fluidisch getrennten Systemen der Gruppe G1 und des einzelnen Untermoduls 30 zwei unterschiedliche Kühlmedien M1 und M2. Das einzelne Untermodul 30 kann dabei auch als fluidisch abgeschlossene Gruppe G2 mit nur einem Element betrachtet werden. Diese beiden fluidisch abgeschlossenen Gruppen G1 und G2 können sich alternativ oder zusätzlich auch bezüglich weiterer Parameter unterscheiden. So ist hier die Strömung des Kühlmittels M1 in der ersten Gruppe G1 aktiv angetrieben und in der zweiten Gruppe G2 passiv angetrieben. Es ist auch möglich, dass in einer solchen Gruppe eine Zirkulation eines fluiden Kühlmittels in einem Einphasensystem stattfindet und in einer anderen Gruppe eine Zirkulation in einem Zweiphasensystem stattfindet. Alternativ können jedoch auch alle Gruppen einen Einphasen-Medienkreislauf ausbilden oder es können alle Gruppen einen Zweiphasen-Medienkreislauf ausbilden, je nach den lokalen Gegebenheiten. Diese Wahl kann z.B. davon abhängig gemacht werden, ob jeweils genügend Bauraum und/oder elektrische Anschlüsse für eine zusätzliche Pumpe 51 zur Verfügung stehen und wie die lokalen Anforderungen an die zu erreichende Kühlleistung sind.

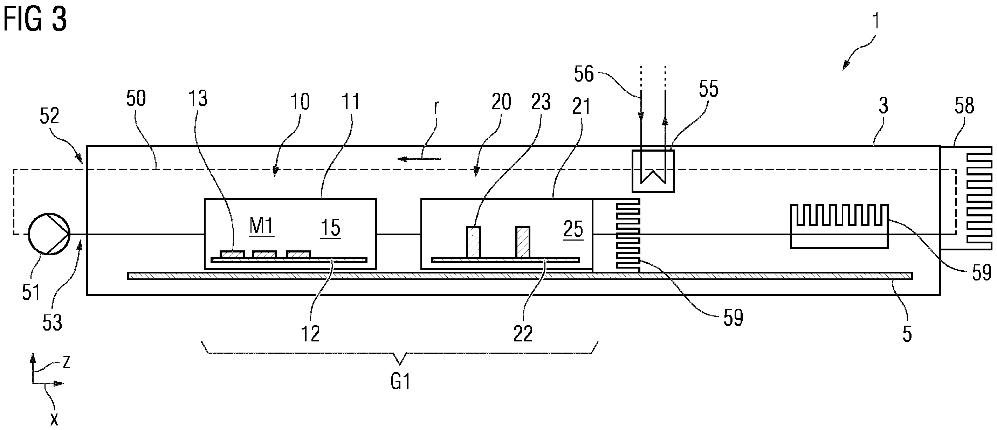

In Figur 3 ist ein Stromrichtermodul 1 nach einem dritten Beispiel der Erfindung im vergleichbaren schematischen Querschnitt gezeigt. Das Stromrichtermodul 1 ist insgesamt ähnlich aufgebaut wie beim vorherigen Ausführungsbeispiel, hier sind jedoch der Übersichtlichkeit halber nur die ersten beiden Untermodule 10 und 20 gezeigt, die zusammen eine fluidisch gekoppelte Gruppe G1 ausbilden. Im Unterschied zum vorhergehenden Beispiel liegt der übergeordnete Medienkreislauf dieser Gruppe G1 nicht vollständig innerhalb des übergeordneten Gehäuses 3, sondern ein Teil des Leitungssystems 50 erstreckt sich in Bereiche außerhalb des Gehäuses 3. So weist das Gehäuse 3 im linken Teil der Figur 3 einen Medieneinlass (Medienzulauf) 52 und einen Medienauslass (Medienablauf) 53 auf. Durch diese beiden Medienanschlüsse 52, 53 ist der Medienkreislauf der Gruppe G1 hier mit einer außerhalb des Gehäuses liegenden Pumpe 51 verbunden. Das Modulgehäuse 3 weist hier also zwei zusätzliche Medien-Schnittstellen 52, 53 auf, was bei den Beispielen der Figuren 1 und 2 nicht der Fall war. Dies macht die Einbindung des Stromrichtermoduls der Figur 3 in eine übergeordnete Anlage etwas aufwändiger als bei den vorhergehenden Beispielen. Allerdings kann mit einer solchen externen Pumpe 51 insbesondere ein besonders hoher Kühlmitteldurchsatz und somit eine effiziente Entwärmung erreicht werden. Dies kann bei einem geringen Bauraum des Modulgehäuses 3 erreicht werden, da die Pumpe 51 außerhalb dieses Gehäuses liegt. Die hier gezeigte externe Pumpe 51 muss insbesondere nicht Teil des erfindungsgemäßen Stromrichtermoduls 1, so dass das Stromrichtermodul 1 im linken Teil der Figur 3 im Bereich der beiden Medienanschlüsse 52 und 53 enden kann.

Das Stromrichtermodul 1 der Figur 3 weist außerdem eine Mehrzahl von sekundären Kühlelementen 55, 58 und 59 auf, die zur Abfuhr von Wärme aus dem Kühlmittelkreislauf der fluidisch abgeschlossenen Gruppe G1 dienen. So ist eines dieser Kühlelemente als Wärmeübertrager 55 ausgestaltet. Dieser Wärmeübertrager 55 kann ein Gegenstrom-Wärmeübertrager sein, welcher an einer Außenwand des übergeordneten Gehäuses 3 angeordnet ist. Durch ihn wird Wärme aus dem Kühlmedium M1 des gezeigten Medienkreislaufs durch externe Medienanschlüsse 56 auf ein weiteres Kühlmedium übertragen. Auch dieses weitere Kühlmedium kann in einem geschlossenen Kreislauf zirkulieren, welcher im Wesentlichen außerhalb des Stromrichtermoduls 1 liegt. Alternativ kann dieses weitere Kühlmedium auch in einem offenen Kreislauf in den Wärmeübertrager 55 eingeströmt werden. Z.B. können die Medienanschlüsse 56 als Kühlwasseranschlüsse ausgestaltet sein, wobei ständig frisches Kühlwasser zugeführt wird. Auch bei einem solchen Wärmeübertrager 55 werden also im Vergleich zu einer reinen Luftkühlung weitere Medienschnittstellen im Bereich des Gehäuses 3 eingeführt. Bei den anderen sekundären Kühlelementen ist dies nicht der Fall. So ist mit 58 ein außenliegender Kühlkörper bezeichnet, welcher außen an dem Modulgehäuse 3 angebracht ist. Dieser außenliegende Kühlkörper 58 kann in einem innenliegenden Medienkanal von dem Kühlmedium M1 durchströmt werden, er kann also insbesondere einen Teil des beschriebenen geschlossenen Medienkreislaufs ausbilden. Auf einer Außenseite des Stromrichtermoduls 1 kann dieser außenliegende Kühlkörper 58 beispielsweise eine Mehrzahl von Kühlrippen zur erhöhten Wärmeabgabe an die Umgebungsluft aufweisen.

Beispielhaft sind hier noch zwei innenliegende Kühlkörper 59 gezeigt, welche innerhalb des übergeordneten Modulgehäuses 3 angeordnet sind. Auch diese beiden innenliegenden Kühlkörper weisen innenliegende Kanäle auf, in denen sie von dem Kühlmedium M1 durchströmt werden. Einer dieser innenliegenden Kühlkörper 59 ist auf der Außenseite des zweiten Modulgehäuses 21 angeordnet, analog zur Anordnung des Kühlkörpers 58 auf dem übergeordneten Gehäuse 3. Ein anderer dieser innenliegenden Kühlkörper 59 ist separat von den Untermodulen 10 und 20 in einem sonstigen Bereich innerhalb des Gehäuses 3 angeordnet. Beide innenliegenden Kühlkörper 59 eignen sich daher zur Abgabe von Wärme aus dem Kühlmedium M1 an das Medium (z.B. Luft), mit dem das Modulgehäuse 3 befüllt ist. Die hier dargestellte Mehrzahl von sekundären Kühlelementen 55, 58 und 59 soll allerdings nur die Variationsbreite verdeutlichen, und es nicht erforderlich, dass die verschiedenen Ausführungen innerhalb eines Stromrichtermoduls vorliegen. Auch die Pumpe 51 zur Zirkulation des Kühlmittels kann alternativ oder zusätzlich innerhalb des übergeordneten Gehäuses 3 liegen, optional auch innerhalb ein oder mehrerer Untermodulgehäuse 11 bzw. 21.

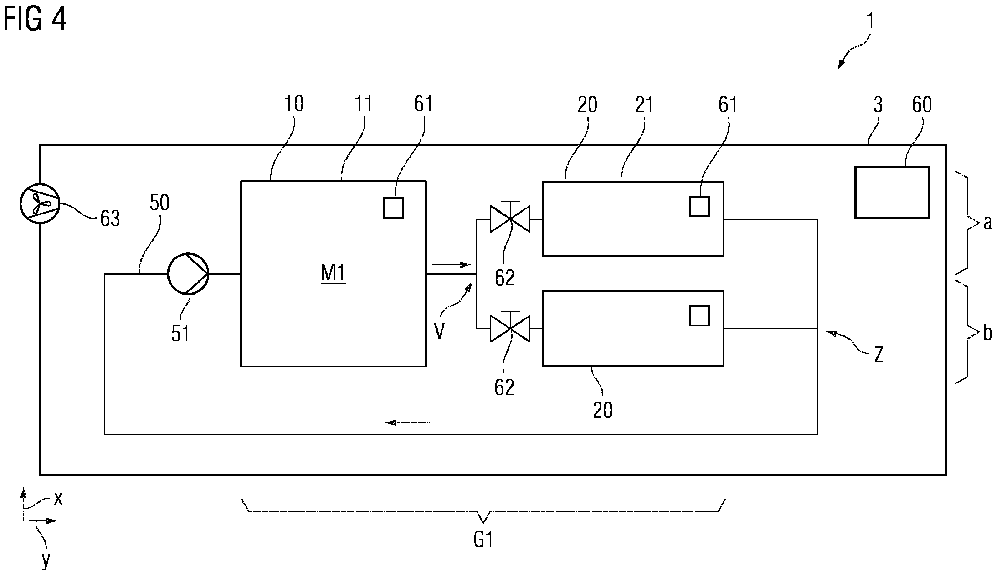

In Figur 4 ist ein Stromrichtermodul 1 nach einem vierten Beispiel der Erfindung im vergleichbaren schematischen Querschnitt gezeigt. Der Übersichtlichkeit halber ist hier nur eine fluidisch abgeschlossene Gruppe G1 gezeigt, welche drei fluidisch miteinander gekoppelte Untermodule umfasst, nämlich ein erstes Untermodul 10 und zwei zweite Untermodule 20. Die einzelnen Teilelemente der Untermodule (abgesehen von den Untermodulgehäusen 11 und 21) sind hier der Übersichtlichkeit halber nicht näher dargestellt, können aber z.B. analog zu den vorhergehenden Beispielen ausgeführt sein. Auch hier ist durch ein Leitungssystem 50 ein insgesamt ringförmig geschlossener Medienkreislauf für ein Kühlmedium M1 ausgebildet. Die Strömung in diesem Medienkreislauf wird hier von einer innenliegenden Pumpe 51 angetrieben. Alternativ könnte es aber auch eine außenliegende Pumpe oder ein passiv angetriebener Medienkreislauf sein. Zwischen dem ersten Untermodul 10 und den beiden zweiten Untermodulen 20 weist das Leitungssystem 50 eine Verzweigung V auf, bei der sich das Leitungssystem 50 in zwei parallel zueinander verlaufende Strömungszweige a und b verzweigt. Diese beiden Strömungszweige a und b laufen beim Zusammenlauf Z wieder zusammen. In jedem dieser einzelnen Strömungszweige a und b liegt ein zugeordnetes zweites Untermodul 20. Alternativ könnten jedoch auch mehrere Untermodule in einem solchen Strömungszweig angeordnet sein, und es können insgesamt auch mehr als zwei parallele Strömungszweige vorliegen. Die gezeigte Topologie soll also nur beispielhaft für einen verzweigten Strömungspfad stehen, und es sind insbesondere auch Topologien mit mehreren Verzweigungen und entsprechenden Zusammenflüssen möglich.

Das Stromrichtermodul 1 der Figur 4 weist eine Regelungsvorrichtung auf, mit welcher ein Durchfluss durch die beiden parallelen Strömungszweige a und b bedarfsgerecht automatisiert geregelt werden kann. Diese Regelungsvorrichtung umfasst in diesem Beispiel eine Steuereinheit 60, mehrere Sensoren 61 und mehrere regelbare Ventile 62. Die Steuereinheit 60 kann insbesondere eine computergestützt automatisierte Steuereinheit 60 sein, welche mittels einer geeigneten Software einen Steuer- bzw. Regelungsalgorithmus ausführen kann. Bei dieser Software können auch Methoden des maschinellen Lernens zum Einsatz kommen. Die Sensoren 61 sind hier innerhalb der einzelnen zweiten Untermodule 20 angeordnet und können beispielsweise als Temperatursensoren ausgestaltet sein. So kann über diese Sensoren 61 insbesondere gemessen werden, ob ein vorgegebener Bereich für die Betriebstemperatur des jeweiligen Untermoduls eingehalten wird. Abhängig von dem jeweiligen Sensorsignal (das über eine hier nicht dargestellte Kommunikationsschnittstelle, z.B. drahtlos an die Steuereinheit 60 übermittelt wird), kann die Steuereinheit 60 Steuersignale an die beiden Ventile 62 senden. Mit diesen Ventilen 62 ist eine Regelung des Durchflusses durch die parallelen Strömungszweige a und b möglich. So kann abhängig von einer in den jeweiligen Untermodulen 20 bei einem gegebenen Betriebszustand dissipierten Leistung und abhängig vom jeweils aktuell ausgebildeten Temperaturprofil eine bedarfsangepasste Durchflussregelung erfolgen. Eine solche automatisierte Durchflussregelung ist jedoch nicht auf einen verzweigten Strömungspfad beschränkt. In ähnlicher Weise kann z.B. auch eine Pumpleistung der in den Figuren 2 und 3 dargestellten Pumpen 51 in Abhängigkeit von einem Sensorsignal geregelt werden, um eine bedarfsgerechte Kühlung der jeweiligen Untermodule 10 und 20 auch in einem unverzweigten Medienkreislauf zu ermöglichen.

Optional können auch hier wieder Kühlkörper zur Förderung der Wärmeabgabe an die Luft im Innenraum des Gehäuses 3 zu Einsatz kommen, ähnlich wie beim Beispiel der Figur 3. Die Abgabe der durch das Kühlmedium M1 gespreizten Wärme an die äußere Umgebung des Stromrichtermoduls 1 kann durch einen Lüfter 63 gefördert werden, welcher beispielsweise in eine Wand des übergeordneten Gehäuses 3 integriert ist. Das Kühlmedium M1 kann insbesondere ein flüssiges Kühlmedium sein. Das Stromrichtermodul 1 der Figur 4 weist dann insgesamt ein hybrides Kühlsystem auf, welches auf einer Kombination von Luftkühlung und Flüssigkeitskühlung basiert. Bei einem solchen hybriden Kühlsystem kommen die Vorteile einer sensorgesteuerten Durchflussregelung besonders wirksam zum Tragen. Beispielsweise kann der Durchfluss des Kühlmediums M1 durch den Medienkreislauf abhängig von der jeweiligen Leistung des Stromrichtermoduls 1 geregelt werden. Zusätzlich kann auch die Leistung des Lüfters 63 abhängig von solch einem Sensorwert geregelt werden.

So kann beispielsweise bei niedrigen Lastbedingungen, wenn im Stromrichtermodul 1 wenig Wärme dissipiert wird, der Kreislauf des flüssigen Kühlmediums M1 rein passiv betrieben werden. Mit anderen Worten sind sowohl die Pumpe 51 als auch der Lüfter 63 in diesem Betriebsmodus ausgeschaltet. Bei mittleren Lastbedingungen wird etwas mehr Wärme dissipiert, und der Lüfter 63 kann aktiviert werden. Dies unterstützt die passive Flüssigkeitskühlung dahingehend, dass die Wärmeabfuhr von den einzelnen Untermodulgehäusen 11 bzw. 21 durch die im übergeordneten Gehäuse 3 nun stärker zirkulierende Luft gefördert wird. Bei hohen Lastbedingungen wird noch mehr Wärme dissipiert.

Entsprechend kann nun auch die Pumpe 51 aktiviert werden, um durch das Zusammenspiel von aktiver Flüssigkeitskühlung und Luftkühlung eine noch effektivere Entwärmung zu fördern.

Insgesamt kann die Leistung des Lüfters 63 und der Flüssigkeitspumpe 51 von der Steuereinheit 60 dynamisch geregelt werden. Allgemein kann diese Regelung abhängig von dem Signal eines Sensors 61 erfolgen, mit dem beispielsweise eine Temperatur oder eine Leistung gemessen wird. Bei zeitlich stark schwankenden Lastbedingungen kann dynamisch zwischen den oben beschriebenen Szenarien gewechselt werden, und die Leistung von Lüfter 63 und Pumpe 51 kann kontinuierlich an den Kühlbedarf angepasst werden. So kann das System zwischen den beiden Kühlmethoden wechseln oder auch beide gleichzeitig mit wechselnder Leistungsaufnahme in Pumpe 51 und Lüfter 63 nutzen. So kann das Kühlsystem sehr schnell auf Leistungsänderungen reagieren, und Überhitzungen der elektrischen Elemente 13, 23 und 33 können vermieden werden. Das Verfahren zur Regelung der Leistung von Pumpe 51 und Lüfter 63 kann beispielsweise so betrieben werden, dass bei möglichst geringem Energieeinsatz vorgegebene Temperaturgrenzen im Bereich der einzelnen Untermodule eingehalten werden. Alternativ oder zusätzlich zu einer Optimierung auf einen niedrigen Energieverbrauch kann auch auf möglichst niedrige Betriebskosten optimiert werden. So können beispielsweise die Kosten für den Betrieb der Pumpe 51 im Vergleich zum Betrieb des Lüfters 63 bewertet werden, und die Steuereinheit 60 kann beide Elemente 51 und 63 so regeln, dass eine Einhaltung von vorgegebenen Temperaturgrenzen bei möglichst niedrigen Betriebskosten erreicht wird. Insgesamt wird durch ein solches hybrides Kühlsystem eine zuverlässige Kühlung des Stromrichtermoduls bei gleichzeitiger Ressourceneffizienz erreicht.

### Bezugszeichenliste

- 1: Stromrichtermodul
- 3: übergeordnetes Gehäuse (Modulgehäuse)
- 5: Hauptplatine
- 10: erstes Untermodul (Leistungsmodul)
- 11: erstes Untermodulgehäuse
- 12: erste Untermodulplatine
- 13: elektrisches Element (leistungselektronisches Schaltelement)
- 15: erste Medienkammer
- 20: zweites Untermodul (Kondensatormodul)
- 21: zweites Untermodulgehäuse
- 22: zweite Untermodulplatine
- 23: elektrisches Element (Kondensator)
- 25: zweite Medienkammer
- 30: drittes Untermodul (Treibermodul)
- 31: drittes Untermodulgehäuse
- 32: dritte Untermodulplatine
- 33: elektrisches Element (Gate-Treiber-Schaltungsanordnung)
- 34: Teilelement
- 35: dritte Medienkammer
- 40: viertes Untermodul
- 42: vierte Untermodulplatine
- 43: elektrisches Element
- 50: Leitungssystem (Medienleitung)
- 51: Pumpe
- 52: Medieneinlass
- 53: Medienauslass
- 55: Wärmeübertrager
- 56: externe Medienleitung
- 58: außenliegender Kühlkörper
- 59: innenliegender Kühlkörper
- 60: Steuereinheit
- 61: Sensor
- 62: Ventil
- 63: Lüfter
- a,b: Strömungszweige
- G1: fluidisch gekoppelte Gruppe
- G2: fluidisch abgeschlossene Gruppe
- M1: erstes Kühlmedium
- M2: zweites Kühlmedium
- r: bevorzugte Strömungsrichtung
- V: Verzweigung
- x,y: laterale Raumrichtungen
- z: vertikale Raumrichtung
- Z: Zusammenlauf

## Patentansprüche

1. Stromrichtermodul (1) umfassend
- ein übergeordnetes Gehäuse (3), welches eine Mehrzahl von Untermodulen (10,20,30,40) gemeinsam umschließt,
- eine Mehrzahl von elektrischen Elementen (13,23,33,43), die jeweils einem einzelnen der Untermodule (10,20,30,40) zugeordnet sind und die aus der folgenden Liste ausgewählt sind:
- leistungselektronische Schaltelemente (13),
- Schaltungsanordnungen (33) die als Gate-Treiber für ein leistungselektronisches Schaltelement ausgebildet sind,
- elektrische Kondensatoren (32) und/oder
- elektrische Spulen
- sowie eine Anzahl von Untermodulgehäusen (11,21,31), welche jeweils einem Untermodul (10,20,30) zugeordnet sind und welche die elektrischen Elemente (13,23,33) dieses Untermoduls (10,20,30) umschließen,
- wobei im Inneren der Untermodulgehäuse (11,21,31) jeweils eine Medienkammer (15,25,35) ausgebildet ist, welche mittels einer Außenwand des jeweiligen Untermodulgehäuses (11,21,31) gegen die Umgebung des jeweiligen Untermoduls (10,20,30) fluiddicht gekapselt ist,
- wobei die jeweilige Medienkammer (15,25,35) im betriebsbereiten Zustand mit einem elektrisch isolierenden fluiden Kühlmedium (M1,M2) befüllt ist,
- und wobei innerhalb wenigstens einer der vorhandenen Medienkammern (15,25,35) das fluide Kühlmedium (M1,M2) derart zirkulieren kann, dass es einen elektrisch aktiven Teilbereich eines elektrischen Elements (13,23,33) des jeweiligen Untermoduls (10,20,30) anströmt.

2. Stromrichtermodul (1) nach Anspruch 1, bei welchem das Kühlmedium (M1,M2) ein dielektrisches Öl ist.

3. Stromrichtermodul (1) nach einem Ansprüche 1 oder 2, bei welchem ein Gesamtvolumen des im Stromrichtermodul zirkulierenden Kühlmediums (M1,M2) im Bereich zwischen 10 Millilitern und 5 Litern, bevorzugt zwischen 100 Millilitern und 5 Litern liegt.

4. Stromrichtermodul (1) nach einem der vorhergehenden Ansprüche, bei welchem im jeweiligen Untermodul (10,20,30) das Untermodulgehäuse (11,21,31) eine Untermodulplatine (12,22,32) umschließt, welches die einzelnen elektrischen Elemente (13,23,33) des jeweiligen Untermoduls (10,20,30) trägt.

5. Stromrichtermodul (1) nach einem der vorhergehenden Ansprüche, wobei zumindest bei einer ersten Teilmenge der Untermodule (30) die Medienkammern (35) durch die zugeordneten Untermodulgehäuse (31) vollständig nach außen hin gekapselt sind.

6. Stromrichtermodul (1) nach einem der vorhergehenden Ansprüche, bei welchem die einzelnen Medienkammern (15,25,35) einer Mehrzahl von fluidisch voneinander getrennten Gruppen (G1,G2) zugeordnet sind, welche sich insbesondere bezüglich wenigstens eines der folgenden Parameter unterscheiden:
- einer chemischen Zusammensetzung des enthaltenen Kühlmediums (M1,M2),
- einer Anzahl von während der Zirkulation auftretenden Aggregatzuständen des Kühlmediums (M1,M2),
- einer Art des Strömungsantriebs (51) für einen jeweils zugeordneten Medienkreislauf,
- einer innerhalb eines jeweils zugeordneten Medienkreislaufs beim Betrieb auftretenden Maximaltemperatur des Kühlmediums (M1,M2), wobei der Unterschied bei wenigstens 10 °C liegt.

7. Stromrichtermodul (1) nach einem der vorhergehenden Ansprüche, wobei zumindest bei einer zweiten Teilmenge der Untermodule (10,20) die Medienkammern (15,25) mittels eines Leitungssystems (50) fluidisch miteinander gekoppelt ist.

8. Stromrichtermodul (1) nach Anspruch 7, bei welchem zumindest ein Teil der Untermodule (20) der zweiten Teilmenge in parallel zueinander verlaufenden Strömungszweigen (a,b) eines übergeordneten geschlossenen Medienkreislaufs liegen.

9. Stromrichtermodul (1) nach einem der Ansprüche 7 oder 8, welches wenigstens eine Regeleinrichtung (60,61,62) zur automatisierten Regelung eines Durchflusses des fluiden Kühlmediums (M1) durch die Medienkammern (25) der einzelnen Untermodule (20) umfasst.

10. Stromrichtermodul (1) nach Anspruch 9, welches eine Steuereinheit (60) zur Ansteuerung der wenigstens eine Regeleinrichtung aufweist und welches wenigstens ein Sensorelement (61) aufweist, um ein Messsignal als Grundlage für eine Durchflussregelung mittels der Steuereinheit (60) zur Verfügung zu stellen.

11. Stromrichtermodul (1) nach einem der vorhergehenden Ansprüche, welches wenigstens einen geschlossenen Medienkreislauf für das fluide Kühlmedium (M1,M2) umfasst, der vollständig innerhalb des übergeordneten Gehäuses (3) liegt.

12. Stromrichtermodul (1) nach einem der vorhergehenden Ansprüche, welches wenigstens einen Kühlkörper (58,59) und/oder Wärmeübertrager (55) umfasst, wobei der Kühlkörper (58,59) und/oder Wärmeübertrager (55) von dem fluiden Kühlmedium (M1) angeströmt wird und zur Abgabe von Wärme an eine Umgebung des Stromrichtermoduls (1) ausgelegt ist.

13. Verfahren zum Betrieb eines Stromrichtermoduls (1) nach einem der vorhergehenden Ansprüche, welches den folgenden Schritt umfasst:
- Zirkulation des fluiden Kühlmediums (M1 ,M2) in wenigstens einem insgesamt geschlossenen Medienkreislauf.

14. Verfahren nach Anspruch 13, bei welchem eine sensorabhängige Regelung eines Durchflusses des fluiden Kühlmediums (M1) durch den Medienkreislauf, insbesondere durch einzelne Teilbereiche (a,b) des Medienkreislaufs, erfolgt.

15. Verfahren nach Anspruch 14, bei welchem das Stromrichtermodul (1) einen Lüfter (63) zur Förderung einer Luftzirkulation durch das übergeordnete Gehäuse (3) aufweist, wobei eine sensorabhängige Regelung sowohl für diese Luftzirkulation als auch für den Durchfluss des fluiden Kühlmediums (M1) durch den geschlossenen Medienkreislauf erfolgt.
